# EUROPEAN PATENT APPLICATION

(11) **EP 4 220 949 A1**
(43) Date of publication of application: **02.08.2023**
(21) Application number: 22153475.3
(22) Date of filing: 26.01.2022
(51) Int. Cl.: H03F 1/32, H03F 3/193, H03F 3/24

(54) **SYSTEM FOR PROCESSING A SIGNAL AND METHOD OF AUTOMATICALLY SETTING A SYSTEM**

(71) Applicant: Rohde & Schwarz GmbH & Co. KG, 81671 München (DE)
(72) Inventor: Bart, Alex, 81671 München (DE); Leitenstorfer, Johannes, 81671 München (DE)
(74) Representative: Prinz & Partner mbB

(57) **Abstract**

The invention relates to a system (10) for processing a signal. The system (10) comprises an amplifier stage (12) and an optimization module (22) that is configured to optimize settings of parameters of the amplifier stage (12). The amplifier stage (12) comprises at least one amplifier (16) and a modulator (14). The parameters correspond to a modulation error ratio (MER), an adjacent channel power ratio (ACPR) and a power efficiency. The optimization module (22) is configured to set a dedicated parameter of the parameters with regard to a defined value while optimizing the other two parameters simultaneously. Further, a method of automatically setting a system (10) for processing a signal is described.

## Description

The invention relates to a system for processing a signal. Further, the invention relates to a method of automatically setting a system for processing a signal.

In the state of the art, systems are known that are used to process signals, for instance systems having an amplifier stage used for broadcasting, e.g. television broadcasting or radio broadcasting.

Typically, these systems comprise several functional modules that can be used to set certain parameters in order to optimize the overall properties of the amplifier stage accordingly. So far, a user or an operator of the system has to manually set the respective parameters by manually interacting with the functional modules, which however requires that the operator has a deeper understanding of the respective relationships of the different parameters to be set. Particularly, it is necessary that the operator has technical knowledge concerning compression in an amplifier stage, intermodulation products, modulation error ratio and power efficiency.

However, this technical knowledge is not always given, particularly at customers' side, so that the respective operators do not use the functional modules in order to do the respective settings of the system, particularly the amplifier stage, resulting in a less efficient signal processing.

Accordingly, there is a need for a system and a method that allow signal processing in an easy and efficient manner.

The invention provides a system for processing a signal, wherein the system comprises an amplifier stage and an optimization module that is configured to optimize settings of parameters of the amplifier stage. The amplifier stage comprises at least one amplifier and a modulator. The parameters correspond to a modulation error ratio (MER), an adjacent channel power ratio (ACPR) and a power efficiency. The optimization module is configured to set a dedicated parameter of the parameters with regard to a defined value while optimizing the other two parameters simultaneously.

The invention also provides a method of automatically setting a system for processing a signal, particularly a system as described above. The method comprises the steps of:
- Optimizing settings of parameters of an amplifier stage by means of an optimization module, wherein the amplifier stage comprises at least one amplifier and a modulator, wherein the parameters correspond to a modulation error ratio (MER), an adjacent channel power ratio (ACPR) and a power efficiency, and
- Setting a dedicated parameter of the parameters with regard to a defined value while optimizing the other two parameters simultaneously.

The main idea of the invention concerns an automatic performance optimization that is done by means of the optimization module that controls respective functional modules associated with the system, particularly the amplifier stage. Thus, it is not necessary that the user or the operator of the system has to manually set the different parameters that influence each other so that an iterative manual optimization process would be necessary. Due to its complexity and the knowledge required, the iterative manual optimization process is typically not done by the respective operator due to lack of experience and/or knowledge with the respective system. Generally, the optimization module is used to optimize three different parameters, namely the modulation error ratio (MER), the adjacent channel power ratio (ACPR) and the power efficiency. The adjacent channel power ratio is associated with intermodulation products that are obtained due to modulating that however also has an influence on the modulation error ratio.

The automatic optimization process as well as the respective system ensure that the power efficiency of the overall amplifier stage is optimized while simultaneously ensuring improved modulation error ratio (MER) and/or adjacent channel power ratio (ACPR). Hence, the optimization enables best possible power efficiency with regard to the best possible modulation error ratio and/or the best possible adjacent channel power ratio.

Of course, the entire system, particularly the amplifier stage, is not damaged due to the settings of the parameters, which are done by the optimization module.

Typically, the power efficiency of the amplifier stage may be improved by degrading the adjacent channel power ratio which however causes a degraded modulation error rate. To avoid this, a manual crest factor reduction would have to be done in order to decouple the degraded adjacent channel power ratio and the degraded modulation error rate from each other.

However, the invention ensures that the manual crest factor reduction is not necessary anymore since the respective functional modules are controlled by means of an automatic performance optimization functionality that is provided by means of the optimization module that optimizes the respective settings of the parameters. In the systems known in the prior art, it is not possible to set two of the afore-mentioned parameters commonly, as a defined value for the adjacent channel power ratio automatically impairs the setting for the modulation error ratio (MER), as both parameters mutually depend on each other.

Since the optimization is done in an automatic manner, the operation of the amplifier stage, particularly the entire system, can be done by an operator or user having less experience as the operator or user only has to set the desired value/setting of the respective parameter. Then, the optimization module automatically optimizes the remaining parameters appropriately while ensuring that the desired value/setting of the respective parameter is achieved.

In general, the modulation error ratio (MER) is a measure used to quantify the performance of a signal processing system, e.g. a transmitter or receiver, using digital modulation, for instance Quadrature amplitude modulation (QAM). A signal sent by an ideal transmitter or received by a receiver would have all constellation points precisely at the ideal locations. However, various imperfections in the implementation, e.g. noise, low image rejection ratio, phase noise, carrier suppression, distortion, etc., or in the signal path cause the actual constellation points to deviate from the ideal locations. In fact, the modulation error ratio is equal to the ratio of the root mean square (RMS) power of a reference vector to the power of the error.

Further, the adjacent channel power ratio (ACPR) is a performance metric used to characterize spectral regrowth in a signal processing system component, such as a modulator. Amplifier nonlinearity causes spectral regrowth. The ACPR is defined as the ratio of power in the adjacent channels of a main channel to the root means square power of the transmitted signal in the main channel.

An aspect provides that the optimization module is configured to optimize the other two parameters automatically while ensuring that the defined setting of the dedicated parameter is achieved, for instance a defined power efficiency. Accordingly, one of the above-mentioned parameters can be set such that the defined value or rather the defined setting is obtained, wherein the other two parameters are optimized automatically. No manual interaction is required anymore, as the optimization module controls the respective settings autonomously.

Another aspect provides that the optimization module is configured to control at least one functional module of the system, thereby decoupling two of the parameters from each other. This ensures that two of these parameters can be set individually. Particularly, the optimization module is configured to control two different functional modules. Thus, all three different parameters can be set/optimized independently of each other.

The system may comprise a direct current supply module that is controlled by the optimization module. A compression of the amplifier stage may be used to decouple the power efficiency and the modulation error ratio (MER) while controlling the direct current supply module appropriately. For instance, the direct current supply module powers the amplifier accordingly. In fact, a decoupling of two of the three parameters is ensured by means of the direct current supply module that is controlled appropriately by the optimization module, namely the power efficiency and the modulation error ratio.

In general, the effect is used that a maximum efficiency of a conventional amplifier is achieved at maximum output power, e.g. when the amplifier is driven in compression. At reduced output power, the efficiency decreases. Hence, the amplifier should be operated in the compression range in terms of efficiency. This can be ensured by controlling the direct current supply module accordingly.

Further, the system may comprise a power adaption module that is controlled by the optimization module. The power adaption module may comprise at least one adaptive filter that is controlled by the optimization module, thereby decoupling the modulation error ratio (MER) and the adjacent channel power ratio (ACPR) from each other. By means of the power adaption module, particularly the at least one adaptive filter, it is ensured that the modulation error ratio (MER) and the adjacent channel power ratio (ACPR) are decoupled from each other such that they can be set independently from each other by means of the optimization module.

The power adaption module differs from a classical crest factor reduction module in that power peaks are not avoided or reduced, but merely shifted to other places in the spectrum, namely at different frequencies, thereby improving the power efficiency of the amplifier stage. This shifting is ensured by means of the adaptive filter that is controlled accordingly by the optimization module. In contrast thereto, a classical crest factor reduction module avoids or rather cuts power peaks in order to reduce the crest factor.

Accordingly, the power adaption module may also be called peak power adaption module (PPAM) or peak power optimization module (PPOM).

Generally, the system may comprise both the direct current supply module and/or the power adaption module. The direct current supply module and the power adaption module both are functional modules that are controlled by the optimization module.

Furthermore, the system may comprise a signal analyzer that is located in a feedback line. For instance, the signal analyzer has two taps, wherein a first tap is located upstream of the amplifier and wherein a second tap is located downstream of the amplifier. Hence, the signal analyzer is enabled to obtain information concerning the signal to be processed. The information obtained by the signal analyzer may be used for controlling purposes. For instance, the respective information gathered is used for controlling the optimization module accordingly such that the optimization module controls the respective functional module(s) with respect to the information gathered by the signal analyzer.

Particularly, the signal is tapped prior to being amplified by means of the amplifier and afterwards, namely the amplified signal, thereby obtaining information concerning the amplification done by the amplifier, e.g. any nonlinearities introduced by the amplifier.

The signal analyzer may be connected with the optimization module, wherein the signal analyzer is configured to analyze the signal processed by the amplifier stage, thereby obtaining an analysis result. The signal analyzer is configured to forward the analysis result to the optimization module. The optimization module may process the analysis result accordingly in order to control at least one of the functional modules appropriately.

The system may comprise a pre-distortion module that is controlled by the signal analyzer. The pre-distortion module may be located upstream of the amplifier. The pre-distortion module may relate to a digital pre-distortion module that is configured to pre-distort the signal to be processed by the respective amplifier located downstream of the pre-distortion module. Hence, nonlinearities introduced by the amplifier may be pre-compensated due to the pre-distortion module.

The pre-distortion module is controlled by means of the signal analyzer that is located in the feedback path. The respective signal analyzer taps the signal prior to its amplification and afterwards, namely by means of two taps located upstream and downstream of the amplifier, respectively.

Generally, the amplifier stage may comprise several amplifiers, for instance a pre-amplifier and a power amplifier. The modulator may be located between both amplifiers, namely the pre-amplifier and the power amplifier. The signal analyzer may be associated with the power amplifier.

The system may be a broadcasting system for digital modulated signals, e.g. orthogonal frequency-division multiplexed or hybrid modulated signals, for instance in-band on-channel signals, namely broadcast signals simultaneously on the same frequency. Particularly the digital modulated signals may correspond to television signals or radio signals. Thus, the signal processed may relate to a digital modulated signal.

In general, the term "module" is understood to describe suitable hardware, suitable software, or a combination of hardware and software that is configured to have a certain functionality, for instance a firmware.

The hardware may, inter alia, comprise a CPU, a GPU, an FPGA, an ASIC, or other types of electronic circuitry.

It is to be understood that a module may be established by a single electronic device or even by a portion of a single electronic device. However, a module may also be established by a plurality of electronic devices that are interconnected, e.g. a network of electronic devices.

Particularly, the optimization module may be part of a modulation module that also comprises the modulator.

The system and the method ensure that the amplifier stage cannot be damaged due to a faulty operation of the system by a user or an operator, as the user or the operator simply sets one of the above-mentioned parameters to the defined value/setting while the other parameters are automatically optimized accordingly. Hence, one of the three parameters can be modified intentionally while ensuring that the amplifier stage is not damaged.

The respective steps for automatically setting the parameters, namely the setting and the optimizing, are done in an iterative manner while checking target values for the respective parameters. Thus, it is ensured that the optimized parameters are obtained while simultaneously ensuring that the defined value for the dedicated parameter is achieved.

The foregoing aspects and many of the attendant advantages of the claimed subject matter will become more readily appreciated as the same become better understood by reference to the following detailed description, when taken in conjunction with the accompanying drawings. In the drawings,
- Figure 1 schematically shows an overview of a system for processing a signal according a first embodiment of the invention,
- Figure 2 shows a detail of the system of Figure 1 according to an exemplary embodiment,
- Figure 3 shows a flow-chart illustrating the method of automatically setting a system for processing a signal according to the invention,
- Figure 4 schematically shows an overview of a system for processing a signal according a second embodiment of the invention, and
- Figure 5 schematically shows an overview of two different embodiments of the system for processing a signal according to the invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

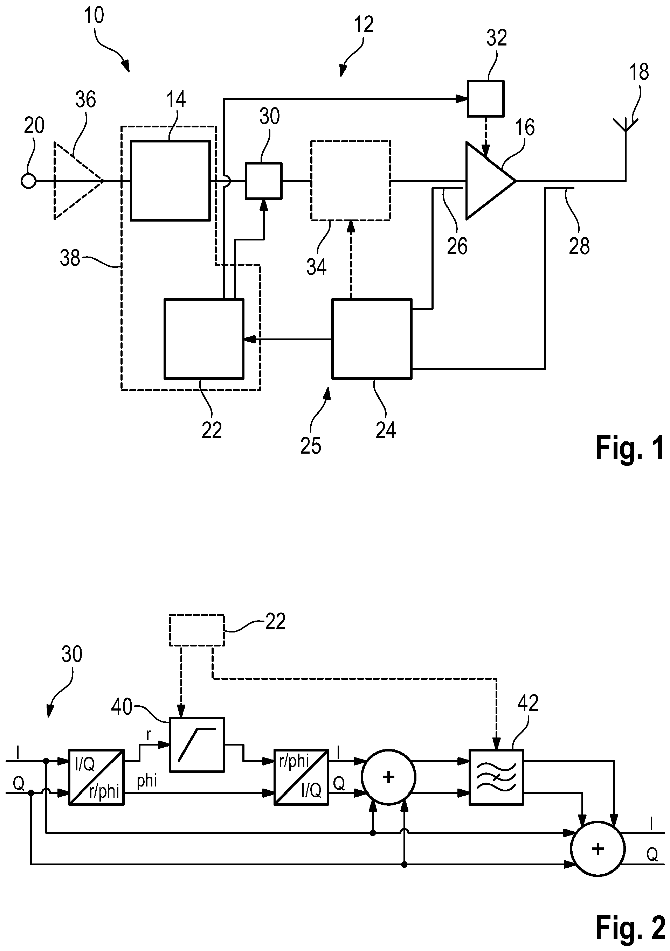

In Figure 1, a system 10 for processing a signal is shown, which may relate to a broadcasting system configured to transmit digital modulated signals, e.g. orthogonal frequency-division multiplexed or hybrid modulated signals, for instance in-band on-channel signals, namely broadcast signals simultaneously on the same frequency. Particularly the digital modulated signals may correspond to television signals or radio signals.

The system 10 comprises an amplifier stage 12 having a modulator 14 and at least one amplifier 16. The amplifier stage 12 is connected to an antenna 18 used for transmitting the signals processed by the system 10, particularly the amplifier stage 12.

Furthermore, the amplifier stage 12 is connected via a node 20 with a signal source (not shown in Figure 1) that provides the signal to be processed by the amplifier stage 12, e.g. data associated with the signal like IQ data (in-phase and quadrature data).

The system 10 further comprises an optimization module 22 used for setting the system 10, particularly functional components, in an automatic manner as will be described later in more detail.

Further, the system 10 also comprises a signal analyzer 24 that is located in a feedback line 25 for controlling the settings of the system 10, particularly the amplifier stage 12. The signal analyzer 24 taps at least one signal processed by the amplifier stage 12 while feeding back information concerning the signal processed for controlling purposes.

In the shown embodiment, the signal analyzer 24 is connected with the optimization module 22 such that an analysis result of the signal analyzer 24 is forwarded to the optimization module 22 that in turn controls the respective functional components accordingly.

Generally, the optimization module 22 and the signal analyzer 24 may be implemented on separately formed hardware, e.g. a cloud circuit. Alternatively, the optimization module 22 and the signal analyzer 24 may be implemented on a common module.

In the shown embodiment, the signal analyzer 24 is integrated into the amplifier stage 12 via two taps, namely a first tap 26 located upstream of the amplifier 16 and a second tap 28 located downstream of the amplifier 16. Thus, a signal to be amplified as well as an amplified signal are tapped by the taps 26, 28 such that the signal analyzer 24 is generally enabled to check the behavior of the amplifier 16, e.g. introduction of nonlinearities by the amplifier 16.

Moreover, the system 10 comprises a power adaption module 30 as well as a direct current supply module 32, both representing functional modules.

The power adaption module 30 as well as the direct current supply module 32 both are connected with the optimization module 22 such that settings of these functional modules may be set by means of the optimization module 22 as will be described later in more detail.

In addition, at least one tap or two taps may be provided upstream the power adaption module 30 and/or downstream the power adaption module 30. Hence, the signal analyzer 24 and/or the optimization module 22 are/is enabled to determine the influence of the power adaption module 30 on the signal processed by the amplifier stage 12. However, these taps are not shown in the Figures for reasons of simplicity.

In the shown embodiment, the system 10 also comprises an optional pre-distortion module 34 that can be controlled by means of the signal analyzer 24 depending on an analysis result obtained by the signal analyzer 24, particularly when analyzing the signals tapped via both taps 26, 28. The -distortion module 34 may be based on a memory polynomial model.

Accordingly, any nonlinearities introduced by the amplifier 16 can be detected by the signal analyzer 24, wherein the pre-distortion module 34 is set so as to pre-compensate for those nonlinearities by pre-distorting the signal to be amplified appropriately.

In Figure 1, a second amplifier 36 is shown that is an optional one. For instance, the second amplifier 36 is a pre-amplifier, whereas the amplifier 16 located downstream of the modulator 14 is a power amplifier.

Moreover, the optimization module 22 and the modulator 14 may be established in a modulation module 38 that comprises both the optimization module 22 and the modulator 14, for instance on a common hardware circuit.

In Figure 2, the power adaption module 30 is shown in more detail.

The power adaption module 30 has at least one adaptive filter 40 that can be controlled by means of the optimization module 22. Hence, the optimization module 22 may adapt the setting of the at least one adaptive filter 40 when controlling the power adaption module 30.

This may cause power peaks in the signal to be processed to be shifted to other places in the spectrum, namely at different frequencies. Hence, the power adaption module 30 differs from a classical crest factor reduction module.

Filter 42 of the power adaption module 30 may then be used to filter the (previously shifted) power peaks. The filter 42 may also be controlled by means of the optimization module 22 such that the filter 42 also corresponds to an adaptive filter.

In other words, the optimization module 22 determines the respective power peaks to be filtered and controls the at least one adaptive filter 40 and the subsequent filter 42 appropriately.

In general, the system 10 is enabled to optimize the settings of parameters of the amplifier stage 12, wherein the respective parameters correspond to a modulation error ratio (MER), an adjacent channel power ratio (ACPR) and a power efficiency.

For this purpose, the optimization module 22 interacts with the power adaption module 30 and the direct current supply module 32.

An operator of the system 10 is enabled to set a dedicated parameter of the above-mentioned three different parameters with regard to a defined value/setting, wherein the optimization module 22 controls both functional modules, namely the direct current supply module 32 and the power adaption module 30, such that the defined setting/value of the dedicated parameter is achieved while automatically optimizing the other two parameters.

Therefore, it is ensured that the best possible power efficiency is obtained with regard to the best possible adjacent channel power ratio (ACPR) and/or the best possible modulation error ratio (MER).

Moreover, the optimization module 22 also ensures that the amplifier stage 12 is not damaged due to a wrong setting of the different parameters, which may occur in case they are set manually.

When controlling the direct current supply module 32, a compression of the amplifier stage 12 is used to decouple the power efficiency and the modulation error ratio (MER). Generally, a maximum efficiency of the amplifier 16 is achieved at maximum output power, namely when the amplifier 16 is driven in compression.

The controlling of the power adaption module 30, particularly the adaptive filter 36, further ensures that the modulation error ratio (MER) and the adjacent channel power ratio (ACPR) are decoupled from each other.

Hence, these three different parameters are decoupled from each other such that each of the different parameters can be set individually without impairing any of the other parameters.

This ensures that a certain value for one of the respective parameters can be achieved while simultaneously optimizing the other parameters.

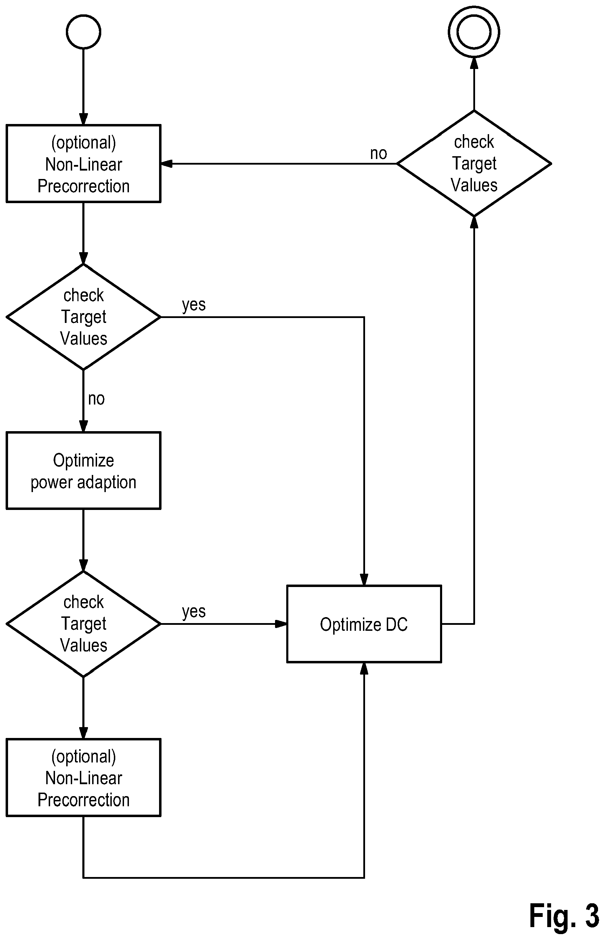

In Figure 3, the respective procedure is shown in more detail, namely the method of automatically setting the above-mentioned system 10 for processing a signal.

At the beginning, an optional non-linear pre-correction may be done by means of the pre-distortion module 34.

Afterwards, the respective target values are checked while analyzing at least one signal obtained by means of the signal analyzer 24.

In case, the respective target values for the parameters are not obtained yet, the power adaption module 30 is controlled by means of the optimization module 22 so as to adapt its settings, particularly the one of the adaptive filter 36, thereby decoupling the modulation error rate from the adjacent channel power ratio by shifting power peaks within the spectrum. Thus, the power efficiency can be improved.

Afterwards, the target values are checked again while analyzing at least one signal obtained by means of the signal analyzer 24.

In case the target values for the parameters are still not achieved, an optional non-linear pre-correction by means of the pre-distortion module 34 can be done (again).

Then or rather in case the target values have already been achieved previously, the optimization module 22 controls the direct current supply module 32 to make use of the compression within the amplifier stage 12 in order to decouple the power efficiency and the modulation error ratio (MER). This is done in the step of optimizing the direct current (DC).

Afterwards, the target values are checked again while analyzing at least one signal obtained by means of the signal analyzer 24.

In case the target values, namely the optimized settings, are not achieved, the respective procedure mentioned above is performed again. Thus, an iterative process is done in order to ensure that the parameters are automatically set in an optimized manner, wherein it is further ensured that the defined value/setting of the dedicated parameter is achieved.

Generally, different functional modules, namely the direct current supply module 32 and the power adaption module 30, as well as the pre-distortion module 34 are controlled accordingly.

Accordingly, an automatic optimization procedure is obtained so as to ensure that one of the modulation error ratio, the adjacent channel power ratio and the power efficiency is set to the defined value, whereas the other two parameters are optimized automatically without any manual input.

Therefore, it is not necessary that the respective operator/user needs deeper technical knowledge about the system 10.

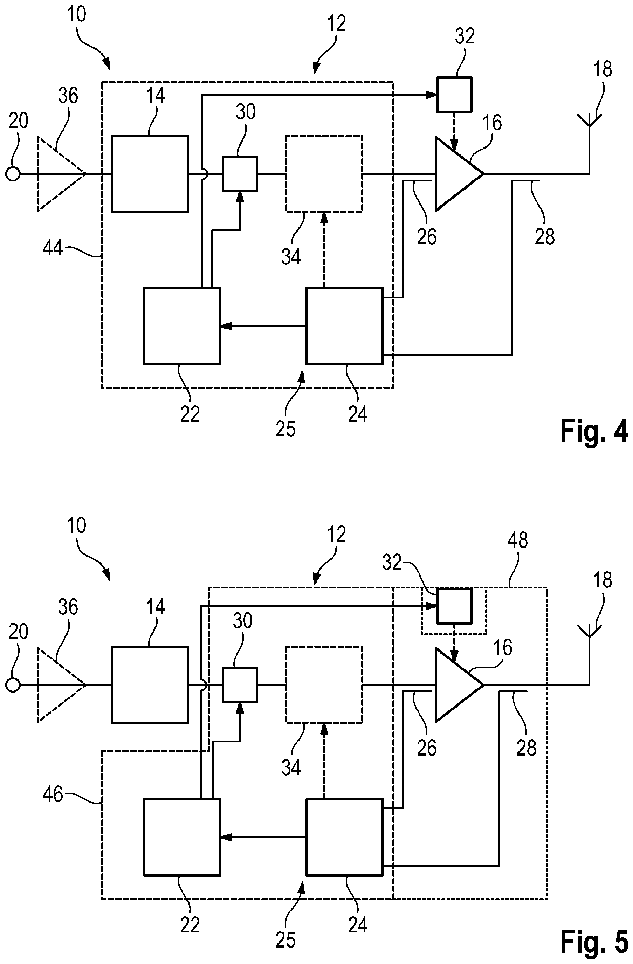

In Figure 4, an alternative embodiment of the system 10 is shown, as the optimization module 22 is part of a superordinate modulator/exciter module 44 that also comprises the modulator 14, the power adaption module 30, the optional pre-distortion module 34 and the signal analyzer 24. The functionality of the system 10 with the superordinate modulator/exciter module 44 is similar to the one described above.

Figure 5 shows two different embodiments of the system 10, as the optimization module 22 is part of a separate superordinate module 46 that also comprises the power adaption module 30, the optional pre-distortion module 34 and the signal analyzer 24. The functionality of the system 10 with the separate superordinate module 46 is similar to the one described above.

Alternatively, Figure 5 shows that the optimization module 22 may be part of an amplifier device 46 that also comprises the power adaption module 30, the optional pre-distortion module 34, the amplifier 16 and the signal analyzer 24 and (eventually) the direct current supply module 32. The functionality of the system 10 with the amplifier device 46 is similar to the one described above

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A system for processing a signal, wherein the system (10) comprises an amplifier stage (12) and an optimization module (22) that is configured to optimize settings of parameters of the amplifier stage (12), wherein the amplifier stage (12) comprises at least one amplifier (16) and a modulator (14), wherein the parameters correspond to a modulation error ratio (MER), an adjacent channel power ratio (ACPR) and a power efficiency, and wherein the optimization module (22) is configured to set a dedicated parameter of the parameters with regard to a defined value while optimizing the other two parameters simultaneously.

2. The system according to claim 1, wherein the optimization module (22) is configured to optimize the other two parameters automatically while ensuring that the defined setting of the dedicated parameter is achieved.

3. The system according to claim 1 or 2, wherein the optimization module (22) is configured to control at least one functional module of the system (10), thereby decoupling two of the parameters from each other, in particular wherein the optimization module (22) is configured to control two different functional modules.

4. The system according to any of the preceding claims, wherein the system (10) comprises a direct current supply module (32) that is controlled by the optimization module (22), in particular wherein a compression of the amplifier stage (12) is used to decouple the power efficiency and the modulation error ratio.

5. The system according to any of the preceding claims, wherein the system (10) comprises a power adaption module (30) that is controlled by the optimization module (22), in particular wherein the power adaption module (30) comprises at least one adaptive filter (40) that is controlled by the optimization module (22), thereby decoupling the modulation error ratio and the adjacent channel power ratio from each other.

6. The system according to any of the preceding claims, wherein the system (10) comprises a signal analyzer (24) that is located in a feedback line (25), in particular wherein the signal analyzer (24) has two taps (26, 28), wherein a first tap (26) is located upstream of the amplifier (16), and wherein a second tap (28) is located downstream of the amplifier (18).

7. The system according to claim 6, wherein the signal analyzer (24) is connected with the optimization module (22), and wherein the signal analyzer (24) is configured to analyze the signal processed by the amplifier stage (12), thereby obtaining an analysis result, and wherein the signal analyzer (24) is configured to forward the analysis result to the optimization module (22).

8. The system according to claim 6 or 7, wherein the system (10) comprises a pre-distortion module (34) that is controlled by the signal analyzer (24), in particular wherein the pre-distortion module (34) is located upstream of the amplifier (16).

9. The system according to any of the preceding claims, wherein the system (10) is a broadcasting system for digital modulated signals.

10. A method of automatically setting a system (10) for processing a signal, wherein the method comprises the steps of:
- Optimizing settings of parameters of an amplifier stage (12) by means of an optimization module (22), wherein the amplifier stage (12) comprises at least one amplifier (16) and a modulator (14), wherein the parameters correspond to a modulation error ratio (MER), an adjacent channel power ratio (ACPR) and a power efficiency, and
- Setting a dedicated parameter of the parameters with regard to a defined value while optimizing the other two parameters simultaneously.

11. The method according to claim 10, wherein at least one functional module is controlled such that two of the parameters are decoupled from each other.

12. The method according to claim 10 or 11, wherein a direct current supply module (32) is controlled by the optimization module (22), wherein a compression of the amplifier stage (12) is used to decouple the power efficiency and the modulation error ratio.

13. The method according to any of claims 10 to 12, wherein a power adaption module (30) is controlled by the optimization module (22), wherein the power adaption module (22) comprises at least one adaptive filter (40) that is controlled by the optimization module (22), thereby decoupling the modulation error ratio and the adjacent channel power ratio from each other.

14. The method according to any of claims 10 to 13, wherein the setting and the optimizing is done in an iterative manner while checking target values for the respective parameters.

15. The method according to any of claims 10 to 14, wherein a pre-distortion module (34) is controlled by the signal analyzer (24).
